(19) Europäisches Patentamt
European Patent Office
Office européen des brevets

(11) **EP 1 710 045 B1**

(12) **EUROPEAN PATENT SPECIFICATION**

(45) Date of publication and mention
of the grant of the patent:
**17.12.2008 Bulletin 2008/51**

(51) Int Cl.:
**B24B 7/22** (2006.01)        **B24B 7/24** (2006.01)
**B24B 37/04** (2006.01)

(21) Application number: **06111884.0**

(22) Date of filing: **29.03.2006**

(54) **A substrate and a method for polishing a substrate**

Trägermaterial und Polierverfahren dafür

Substrat et méthode de polissage d'un substrat

(84) Designated Contracting States:
**AT BE BG CH CY CZ DE DK EE ES FI FR GB GR HU IE IS IT LI LT LU LV MC NL PL PT RO SE SI SK TR**

(30) Priority: **08.04.2005 JP 2005112070**

(43) Date of publication of application:
**11.10.2006 Bulletin 2006/41**

(73) Proprietor: **Ohara Inc.**
**Sagamihara-shi**
**Kanagawa (JP)**

(72) Inventors:
• **Nakamura, Kazuyoshi**
**c/o Ohara Inc.**
**Kanagawa (JP)**

• **Nakajima, Toshihide**
**c/o Ohara Inc.**
**Kanagawa (JP)**
• **Nakajima, Kousuke**
**c/o Ohara Inc.**
**Kanagawa (JP)**
• **Oonami, Takahisa**
**c/o Ohara Inc.**
**Cologen (JP)**

(74) Representative: **Jönsson, Hans-Peter**
**Patentanwälte von Kreisler Selting Werner**
**Deichmannhaus am Dom**
**Bahnhofsvorplatz 1**
**50667 Köln (DE)**

(56) References cited:
WO-A-20/04058451        US-A- 6 159 643
US-A1- 2002 077 036        US-A1- 2004 166 420
US-A1- 2004 192 175

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

This invention relates to a method for polishing a substrate having extremely accurate flatness and surface roughness and, more particularly, to a method for polishing a substrate suitable for use in electronic devices such as a substrate for a mask blank.

In the field of semiconductors, demand for integrated circuits of a higher density is increasing for improving efficiency of handling information. For realizing such higher density integrated circuits, there has been a proposal for a technique of applying exposure wavelength of extreme ultra-violet ray (EUV) in a chip manufacturing process. A mask substrate of an exposure apparatus used in this technique is obtained by polishing an extremely low expansion material and highly accurate flatness and surface roughness are required for such mask substrate. As materials of a mask substrate and a mirror substrate for EUV micro-lithography, extremely low expansion materials such as CLEARCERAM (trademark) of Ohara Inc., Zerodur (trademark) of Schott AG, Zerodur-M (trademark) of Schott GmbH and ULE (trademark) of Corning Incorporated are suitable, for these materials have a very small thermal expansion coefficient and high homogeneity.

US 2004/0166420 A1 relates to the manufacture of a substrate which is particularly suitable for EUV micro-lithography and comprises a base layer of low coefficient of thermal expansion (CTE) onto which at least one cover layer made of a semiconductor material is applied. Preferably, the cover layer is a silicon layer, preferably applied by ion beam sputtering. By an additional ion beam figuring treatment substrates of extremely accurate shape and extremely low roughness can be prepared.

US 2006/0140105 A1 describes the manufacturing of a glass substrate for an information recording medium by polishing the surface of a raw material glass plate. The polishing of the raw material glass plate is divided into a step of performing a first polishing process to roughly polish the surface of the raw material glass plate to be smooth and a step of performing a second polishing process to finely polish the surface of the roughly polished raw material glass plate to be smoother. The first polishing process uses a polishing pad made of a synthetic resin foam and slides the polishing pad on the raw material glass plate surface while supplying a polishing agent to roughly polish the surface. A pad dressing process is performed on the polishing pad before being used in the first polishing process. The pad dressing process polishes the surface of the polishing pad by sliding the polishing pad on a pad dresser including abrasive grains.

US 2003/0077036 A1 discloses an optical fiber collimator which facilitates optical adjustment. The optical fiber collimator includes a gradient index rod lens, and an optical fiber optically connected to the rod lens. An anti-reflection film is formed on one end face of the rod lens. The anti-reflection film has a refractive index which continuously changes from a value substantially equal to that of a center refractive index of the rod lens to a value substantially equal to that of the refractive index of the optical fiber along a film thickness direction of the anti-reflection film. A refractive index matching medium having a refractive index substantially equal to that of the optical fiber bonds the anti-reflection film to the end face of the optical fiber.

WO 2006/082751 A2 describes a process for polishing a glass substrate, which enables to polish a glass substrate having a large waviness formed by mechanical polishing, to have a surface excellent in flatness.

US 2005/0064709 A1 discloses a polishing pad by which optical materials such as lenses, reflecting mirrors etc., or materials requiring a high degree of surface planarity, as in the polishing of silicone wafers, glass substrates or aluminium substrates for hard disks, or general metal polishing, can be flattened with stability and high polishing efficiency. The invention also provides a polishing pad for semiconductor wafers, which is superior in planarizing characteristic, is free from scratches and can be produced at low cost. There is provided a polishing pad which is free from dechucking error so that neither damage to wafers nor decrease in operating efficiency occurs. There is provided a polishing pad which is satisfactory in planarity, within wafer uniformity, and polishing rate and produces less change in polishing rate. There is provided a polishing pad which can make planarity improvement an scratch decrease compatible.

US 2002/0098779 A1 describes the reduction of dishing in chemical mechanical polishing (CUP) by introducing a material that balances electrochemical forces.

Japanese Patent Application Laid-open Publication No. 2004-228563 discloses a method for producing a substrate suited for EUV micro-lithography from such materials. This publication reports that, even if a substrate is polished to surface roughness of 0.1 nm to 0.3 nm at RMS (root-mean-square roughness), application of ion beam processing for achieving desired flatness causes increase in the surface roughness to twofold to five-fold the value before application of the ion beam processing. In this publication, a covering layer is formed on the base layer of the substrate for evading such increase in surface roughness, This method, however, has not realized flatness and surface roughness required for the base layer per se.

Japanese Patent Application Laid-open Publication No. 2004-29735 discloses a substrate for electronic devices and a method for polishing the substrate. The substrate obtained by this polishing method, however, does not exhibit surface property values which are better than flatness of 230 nm and surface roughness Ra of 0.18 nm. Since Ra (arithmetic mean roughness) which is a parameter indicating surface roughness is lower than a value of RMS (root-mean-square roughness), the surface roughness of Ra 0.18 nm is a value exceeding 0.20nm when it is expressed in RMS. Further, a material for a substrate considered in this publication is glass only and no consideration is given to achievement of desired surface property values by polishing materials other than glass including glass-ceramics such as the above mentioned CLEARCERAM of Ohara, Inc.

Thus, in the high accuracy region required by EUV lithography, flatness and surface roughness are surface properties which conflict with each other and, when an attempt is made to achieve one of these surface properties, the other surface property fails to achieve a desired value. In the past, accordingly, there has not been a substrate which satisfies both flatness of less than 230 nmPV (peak-to-value) and surface roughness at RMS of less than 0.20 nm simultaneously without providing a special cover layer on the base layer of the substrate.

It is therefore an object of the present invention to provide a method for polishing substrates, so that these substrates have excellent flatness and surface roughness in the high accuracy region, particularly substrates for liquid crystal display and electronic devices including semiconductor wafers or information recording medium and, more particularly, substrates for EVU micro-lithography, without providing a cover layer but by having such surface properties in the substrate per se.

For achieving the above described objects of the invention, studies and experiments made by the inventors of the present invention have resulted in the finding, which has led to the present invention, that a substrate having excellent flatness and surface roughness in the high accuracy region can be obtained by adopting a specific polishing process.

A substrate can be provided with the method of the invention as described below, having flatness of less than 230 nmPV and surface roughness at RMS of less than 0.20 nm.

A substrate can be provided with the method of the invention as described below, the method comprising:

(a) a process of polishing an object to be polished with a polishing pad comprising at least one layer made of a resin film and having compressibility of 0.8% or below in a base layer of the polishing pad.

A substrate can be provided with the method of the invention as described below, the process (a) comprising:

(a-1) a process of polishing an object to be polished by a polisher while maintaining surface load of 40g/cm$^2$ or below to the object to be polished and supplying a polishing medium.

A substrate can be provided with the method of the invention as described below, the process (a) comprising:

(a-2) a process performed subsequent to the process (a - 1) of polishing the object to be polished by the polisher while supplying only liquid which does not contain a polishing medium.

A substrate can be provided with the method of the invention as described below, wherein in the method the surface load to the object to be polished is maintained at 40g/cm$^2$ or below in the process (a - 2).

A substrate can be provided with the method of the invention as described below, the method comprising:

(b) a process performed prior to the process (a) of polishing the object to be polished to flatness of at least 230 nmPV and surface roughness at RMS of at least 0.4 nm.

A substrate can be provided with the method of the invention as described below, wherein in the method the polishing medium used in the process (a) is a cerium oxide polishing medium.

A substrate can be provided with the method of the invention as described below, wherein in the method an average particle diameter of the polishing medium used in the process (a) is 1.0 $\mu$m or below.

A substrate can be provided with the method of the invention as described below, wherein in the method the concentration of the polishing medium used in the process (a) is 1.0 wt% or below.

A substrate can be provided with the method of the invention as described below, wherein in the method an average linear thermal expansion coefficient is within a range of $0.0 \pm 0.3 \times 10^{-7}/°C$ within temperature range from 0°C to 50°C.

A substrate can be provided with the method of the invention as described below, wherein in the method an average linear thermal expansion coefficient is within a range of $0.0 \pm 0.3 \times 10^{-7}/°C$ within temperature range from 19°C to 25°C.

A substrate can be provided with the method of the invention as described below, comprising $SiO_2$ and $TiO_2$.

A substrate for a photo mask can be provided with the method of the invention as described below, using the substrate as defined above.

A photo mask can be provided with the method of the invention as described below, using the substrate as defined in the previous paragraph.

According to the invention, there is provided a method for polishing a substrate comprising:

(a) a process of polishing an object to be polished with a polishing pad comprising at least one layer made of a resin film and having compressibility of 0.8 % or below in a base layer of the polishing pad.

In a first preferred embodiment of the invention the process (a) comprises:

(a-1) a process of polishing an object to be polished by a polisher while maintaining surface load of 40g/cm$^2$ or below to the object to be polished and supplying a polishing medium.
In the second preferred embodiment of the invention, there is provided a method as defined in the first preferred embodiment wherein the process (a) comprises:

(a-2) a process performed subsequent to the process (a-1) of polishing the object to be polished by the polisher while supplying only liquid which does not contain a polishing medium.

In the third preferred embodiment of the invention, there is provided a method as defined in the second preferred embodiment wherein surface load to the object to be polished is maintained at 40g/cm$^2$ or below in the process (a-2).
In the fourth preferred embodiment of the invention, there is provided a method as defined in any of the first to third preferred embodiments wherein, after the polishing, flatness of the object to be polished is less than 230 nmPV and surface roughness at RMS of the object to be polished is less than 0.20 nm.
In the fifth preferred embodiment of the invention, there is provided a method as defined in any of the first to fourth preferred embodiments comprising:
(b) a process performed prior to the process (a) of polishing the object to be polished to flatness of at least 230 nmPV and surface roughness at RMS of at least 0.4 nm.

In the sixth preferred embodiment of the invention, there is provided a method as defined in any of the first to fifth preferred embodiments wherein the polishing medium used in the process (a) is a cerium oxide polishing medium.
In the seventh preferred embodiment of the invention there is provided a method as defined in any of the first to sixth preferred embodiments wherein an average particle diameter of the polishing medium used in the process (a) is 1.0 μm or below.
In the eighth preferred embodiment of the inversion, there is provided a method as defined in any of the first to seventh preferred embodiments wherein concentration of the polishing medium used in the process (a) is 1.0 wt% or below.
In the ninth preferred embodiment of the invention, there is provided a method as defined in any of the first to eighth preferred embodiments wherein the substrate is a substrate for a photo mask.
With the process of the invention as described above, a substrate can be provided having excellent flatness and surface roughness in the high accuracy region, namely flatness of 100 nmPV or below and surface roughness at RMS of 0.17 nm or below. According to the invention there is provided a method for polishing the substrate without providing a special cover layer but by having such surface properties in the substrate per se. It is of course possible to obtain values of flatness and surface roughness higher than the above described values by adjusting polishing time and other conditions. The substrates are suitable particularly as substrates for liquid crystal display and electronic devices including semiconductor wafers or information recording medium and, more particularly, substrates for photo mask and more particularly as substrates of photo mask for EVU micro-lithography.
According to the invention, no special process other than a polishing process such as providing a special cover layer is required for realizing flatness and surface roughness in the high accuracy region and, therefore, the substrates can be manufactured at a low cost.
The substrate should preferably have flatness of less than 230 nmPV(peak-to-valley) and surface roughness at RMS of less than 0.20 nm. By realizing these surface property values, the present application can be applied to substrates requiring high accuracy properties. Particularly, for applying the invention to a mask substrate of an exposure device using exposure wavelength of extreme ultra-violet ray, more preferably flatness is 150 nmPV or below and the most preferable flatness is 100 nmPV or below, and more preferable surface roughness at RMS is 0.18 nm or below and the most preferable surface roughness at RMS is 0.17 nm or below. When surface roughness is expressed in Ra, preferable surface roughness Ra is less than 0.18 nm, more preferable Ra is 0.16 nm or below and the most preferable Ra is 0.12 nm or below.
RMS herein is used in the same meaning as Rq, i.e., "root-mean-square roughness". For measuring RMS, an atomic scope microscope is used as a measuring instrument and measurement was made with the scope of measurement of 5μm×5μm. Ra herein means "arithmetic mean roughness" and conditions for measuring Ra are the same as those for RMS. PV (peak-to-valley) herein has the same meaning as flatness and represents sum of maximum height of the peak and maximum depth of the valley from the reference plane. For measuring flatness, an interferometer is used as a measuring instrument and measurement was made with the scope of measurement within 5mm inside of the outer periphery of the substrate.

In case the substrate is used for purposes requiring extremely high accuracy, average linear thermal expansion coefficient should preferably be as low as possible. Particularly, in case the substrate is used for a mask substrate of EUV micro-lithography, the substrate should have average linear thermal expansion coefficient a should preferably within a range of $0.0 \pm 0.3 \times 10^{-7}/°C$, more preferably $0.0 \pm 0.2 \times 10^{-7}/°C$ and, most preferably $0.0 \pm 0.1 \times 10^{-7}/°C$ within temperature range from 0°C to 50°C or within temperature range from 19°C to 25°C.

For realizing the above described thermal expansion property, the substrate should preferably comprise $SiO_2$ and $TiO_2$. Further, an object to be polished comprising these two components facilitates achievement of surface properties which satisfy highly accurate flatness and surface roughness as shown in Examples of the invention by a polishing process to be described later. Mechanism of how such surface properties can be achieved is not known but the inventors of the present invention have derived the concept of the effects of adding these components from their experience. As to amounts of these components, it is preferable that $SiO_2$ should be added, in mass %, in an amount of 50 - 97% and $TiO_2$ should be added, in mass %, in an amount of 1.5 - 10%.

Further, from the above described standpoint, it is most preferable that the substrate should comprise, in mass %, 47 - 65% $SiO_2$, 1 - 13% $P_2O_5$, 17 - 29% $Al_2O_3$, 1 - 8% $Li_2O$, 0.5 - 5% $MgO$, 0.5 - 5.5% $ZnO$, 1 - 7% $TiO_2$ and 1 - 7% $ZrO_2$.

The substrate should preferably be made of glass or glass-ceramics for easily achieving desired surface properties and low thermal expansion property and, most preferably be made of glass-ceramics because glass-ceramics are hardly vulnerable to scratches caused by polishing. Glass-ceramics comprising β-quartz (β□$SiO_2$) and/or β-quartz solid solution (β-$SiO_2$ solid solution) are most preferable since they have low expansion property.

As an object to be polished, extreme low expansion materials such, for example, as CLEARCERAM (Ohara Inc.), Zerodur (Schott AG), Zerodur-M (Schott AG) and ULE (Corning Incorporated) are suitable materials..

The substrate may either be of a circular shape or of a polygonal shape (e.g., square or rectangular). In general, in case a plurality of substrates of a polygonal shape such as a square shape are polished simultaneously by, e.g., a double-side polisher, the shape of each of the substrates sometimes becomes asymmetrical or collapses at a corner. Thus, it is generally more difficult in a substrate having a polygonal shape to achieve highly accurate surface properties than in a substrate having a circular shape. According to the polishing method of the present invention, surface properties having highly accurate flatness and surface roughness as shown in Examples can be achieved, even if the substrate has a polygonal shape.

The polishing method of the present invention comprises process (a) and may, further, comprise processes (b), (a-1) and (a-2). The process (b) is performed prior to the process (a). The process (a) may include process (a-1) and the process (a-2).

These processes of the polishing method of the present invention and relevant processes will now be described.

A preliminary process may be applied before the processes of the invention. For example, an object to be polished may be cut to a desired shape and then may be lapped in the order of primary lapping and secondary lapping by using abrasive grains which become progressively fine. Then, if necessary, processing such as chamfering is made and then polishing is made in the order of primary polishing and secondary polishing, with flatness and surface roughness being caused to approach to desired values. The lapping and polishing processes may be reduced from the above processes or, conversely, more processes may be performed.

Process (b)

In this process, the object to be polished is polished to flatness of at least 230 nmPV and surface roughness of at least 0.4 nm. In this process, surface roughness is caused to approach a desired value and flatness should preferably reach a finally required value. Particularly, for obtaining a mask substrate of EUV micro-lithography, flatness should more preferably be 150 nmPV or below and, most preferably be 100 nmPV or below.

These surface property values can be realized by an MRF polisher using magneto-rheological finishing method (MRF) or a single-side polisher.

The MRF polisher is a polisher which performs finishing by magneto-rheological fine polishing. More specifically, an object to be polished is attached to the upper spindle of a three-axle CNC controlled machine tool and a rotating wheel and the object to be polished are positioned by an NC controller so that they are located within a predetermined distance to each other. An electromagnet is attached under the surface of the wheel and there is generated gradient magnetic-field in which magnetic force becomes maximum in a gap between the object to be polished and the top of the wheel. When a magneto-rheological polishing agent is supplied to this gradient magnetic-field, the polishing agent is attracted onto the surface of the wheel under the influence of the gradient magnetic-field and thereby polishes the object to be polished (cited from the Journal of Abrasive Grain Processing Institute vol. 146, No. 8, 2002 Aug.). The MRF polishing method is described in detail in this journal.

The single-side polisher is a polisher which has a foamed pad attached only to the lower board of an ordinary type of a double-side polisher and polishes an object to be polished with self-weight of the object or outside load being applied to the object to be polished.

It is not easy to achieve final value of surface roughness with such MRF polisher or single-side polisher but, by achieving final value of flatness or a value which is close to the final value of flatness with such polisher, time required for subsequent polishing can be significantly shortened.

Process (a)

In this process, the object to be polished is polished with a polishing pad comprising at least one layer having compressibility of 0.8 % or below in a base layer of the polishing pad.

Compressibility herein means compressibility based on JIS L-1096. More specifically, when thickness measured under condition of load of 60 gf and measuring pressure of 300 $g/cm^2$ with a dial gauge having a tip of $0.20cm^2$ is represented by T1 and thickness measured under condition of load of 360 gf and measuring pressure of 1800 $g/cm^2$ is represented by T2, compressibility is represented by the formula

$$\text{Compressibility (\%)} = ((T1-T2)/T1) \times 100.$$

The polishing pad used in this process has at least two layers of a surface layer and a base layer consisting of one or more layers and it is important to have at least one hard layer having compressibility of 0.8 % or below. By making a layer included in the base layer hard in this manner, surface roughness of a desired final value can be realized while maintaining flatness of a desired final value which has already been achieved in the previous process. For enhancing the effect of the hard layer included in the base layer maintaining desired flatness of the object to be polished, this compressibility should more preferably be 0.2% or below. As the hard layer included in the base layer, a flexible material in the form of a film made of, e.g., plastics, thermoplastic elastomer, rubber and metal may be used. This material may contain foam but preferably should not contain foam. More specifically, epoxy resin, polyurethane resin, polyethylene terephthalate, polycarbonate and stainless steel may be used among which polyethylene terephthalate is preferable. From the standpoint of maintaining flatness, the surface layer should preferably be a single layer and the base layer should preferably be a single layer, i.e., the base layer should preferably consist of a hard layer only.

The surface layer of the polishing pad used in the process (a) should preferably have a nap structure with a diameter of an opening being within a range from 70 $\mu$m to 180 $\mu$m. Surface hardness of the surface layer should preferably be less than 80 in hardness A based on JIS K7311, for this hardness can prevent occurrence of scratches on the surface of the object to be polished. The surface layer of urethane material may preferably be used.

Compressibility of the polishing pad as a whole used in the process (a) should preferably be within a range from 4% to 10% and, more preferably, within a range from 5% to 9.5%. Thickness of the polishing pad as a whole should preferably be within a range from 0.3mm to 0.9mm and, more preferably, within a range from 0.4mm to 0.6mm.

Process (a-1)

This process constitutes one of divided processes of the process (a). In this process, polishing is made by using a polisher having the polishing pad used in the process (a) with surface load on the object to be polished being maintained at 40$g/cm^2$ or below and with a polishing medium being supplied.

As the polisher, either a single-side polisher or a double-side polisher may be used but a double-side polisher may be preferably used, for, in the double-side polisher, there is no likelihood that while one surface is being polished, the other surface is soiled and time for processing is shorter than a single-side polisher. The revolution number of the polisher should preferably be within a range from 30 revolutions/minute to 50 revolutions/minute, more preferably within a range from 30 revolutions/minute to 40 revolutions/minute and, most preferably, within a range from 40 revolutions/minute to 50 revolutions/minute.

For achieving desired flatness and surface roughness, processing time should preferably be within a range from 5 minutes to 20 minutes, more preferably within a range from 5 minutes to 10 minutes and, most preferably, within a range from 7 minutes to 10 minutes.

A low surface load of the polishing pad on an object to be polished is an important factor for achieving desired surface roughness while maintaining flatness. More specifically, the surface load on the object to be polished should preferably be 40$g/cm^2$ or below, more preferably be 35$g/cm^2$ or below and, most preferably, be 28$g/cm^2$ or below.

There is no particular limitation in the polishing medium to be used and conventional polishing media including colloidal silica and cerium oxide, for example, may be used. Cerium oxide is particularly preferable as the polishing medium because a high polishing speed can be achieved by using this polishing medium. Concentration of a polishing medium should preferably be 1.0 wt% or below for achieving a desired value of surface roughness, more preferably be 0.5 wt% or below and, most preferably be 0.1 wt% or below. For the same reason, average particle diameter of the polishing medium should preferably be 1.0 $\mu$m or below, more preferably be 0.5 $\mu$m or below and, most preferably be 0.4 $\mu$m or below.

Process (a-2)

This process is the other part of the divided process (a) and is performed after the process (a-1). In this process, polishing is made by using a polisher having the polishing pad used in the process (a) with surface load on the object to be polished being maintained at 40g/cm$^2$ or below and with a liquid containing no polishing medium being supplied. Another process may be inserted between the process (a-1) and the process (a-2) but normally the process (a-1) is completed by stopping supply of the polishing medium in the process (a-1) and the process (a-2) is started successively by starting supply of the liquid containing no polishing medium.

By making polishing by supplying a liquid which does not contain a polishing medium, grains of the polishing medium which have entered fine depressions on the surface of the object to be polished are removed and occurrence of scratches on the surface of the object to be polished can be prevented.

As the liquid which does not contain a polishing medium, a liquid of pH 6 to pH8 is preferable and tap water may be used as a suitable liquid. Pure water and ion exchange water may also be used and a buffer solution may also be used with such water. A case where a very small amount of a polishing medium remaining in the supply path of the liquid is supplied with the liquid is included in the process (a-2).

As the polisher, either a single-side polisher or a double-side polisher may be used but a double-side polisher may be preferably used, for, in the double-side polisher, there is no likelihood that while one surface is being polished, the other surface is soiled and time for processing is shorter than a single-side polisher. The revolution number of the polisher should preferably be within a range from 30 revolutions/minute to 50 revolutions/minute, more preferably within a range from 30 revolutions/minute to 40 revolutions/minute and, most preferably, within a range from 40 revolutions/minute to 50 revolutions/minute.

Processing time should preferably be within 30 minutes, more preferably within 15 minutes and, most preferably, within 10 minutes.

A low surface load of the polishing pad on an object to be polished is an important factor for achieving desired surface roughness while maintaining flatness. More specifically, the surface load on the object to be polished should preferably be 40g/cm$^2$ or below, more preferably be 35g/cm$^2$ or below and, most preferably, be 28g/cm$^2$ or below.

Examples

Preliminary process

Extreme low expansion glass-ceramics were cut to substrates of 155mm$\times$155mm$\times$7.5mm and lapped by a double-side lapper. This lapping process was divided into two steps of primary lapping and secondary lapping by changing conditions of lapping such as abrasive grain.

In the primary lapping, a double-side lapper was used with free abrasive grain of #1500 and at revolution number of 20 revolutions/minute. PV of the substrate after the primary lapping was all 3 $\mu$m.

The secondary lapping was made by using a lapper which was different from the lapper for the primary lapping with free abrasive grain of #1500 and at a revolution number of 20 revolutions/minute. PV of the substrate after the secondary lapping was 1 - 2 $\mu$m.

Then, the end faces were chamfered and polishing was made by using a double-side polisher. In the polishing also, the polishing process was also divided into two steps of primary polishing and secondary polishing.

Process (b)

The MRF polisher made by QED was used for removing fine distortions and scratches which were not removed by the polishing medium and flatness of 150 nmPV or below and surface roughness of 0.4 nmRMS or below were achieved.

Process (a)

Process (a-1)

Polishing was made by using a double-side polisher with surface load on the object to be polished being maintained at 40g/cm$^2$ or below and supplying a polishing medium. As the polishing pad, a polishing pad having a base layer consisting of a single layer made of PET film having compressibility of 0.1% and having a surface layer consisting of a single layer of a nap structure was used. As the polishing medium, cerium oxide was used.

Process (a-2)

After the process (a-1), supply of the polishing medium was stopped and polishing using only tap water was started with surface load being maintained at $40g/cm^2$. As the polishing pad, the pad which was used in the process (a-1) was used.

Tables 1 and 2 show examples of the present invention with respect to conditions of the respective processes and surface property values measured after completion of these processes.

Table 1

| | Example | 1 | 2 | 3 |
|---|---|---|---|---|
| Material | $SiO_2$(wt%) | 55.0 | 55.0 | 55.0 |
| | $TiO_2$(wt%) | 2.5 | 2.5 | 2.5 |
| | $P_2O_5$(wt%) | 8.0 | 8.0 | 8.0 |
| | $Al_2O_3$(wt%) | 24.0 | 24.0 | 24.0 |
| | $Li_2O$(wt%) | 4.0 | 4.0 | 4.0 |
| | MgO(wt%) | 0.8 | 1.0 | 1.0 |
| | ZnO(wt%) | 0.5 | 0.5 | 0.5 |
| | CaO(wt%) | 1.2 | 1.0 | 1.0 |
| | BaO(wt%) | 1.0 | 1.0 | 1.0 |
| | $ZrO_2$(wt%) | 2.0 | 2.0 | 2.0 |
| | $As_2O_3$(wt%) | 1.0 | 1.0 | 1.0 |
| Predominant crystal phase | | β-quartz/ β-quartz solid solution | β-quartz/ β-quartz solid solution | β-quartz/ β-quartz solid solution |
| α(0 - 50˚C) | | $0.1\times10^{-7}$ | $0.2\times10^{-7}$ | $-0.1\times10^{-7}$ |
| | α(19 - 25˚C) | $0.1\times10^{-7}$ | $0.2x10^{-7}$ | $-0.1\times10^{-7}$ |
| Primary polishing | | | | |
| polishing medium | | cerium oxide | cerium oxide | cerium oxide |
| rev./min. | | 50 | 50 | 50 |
| polishing pad | | MHC15A (Rodel) | MHC15A (Rodel) | MHC15A (Rodel) |
| After primary polishing | | | | |
| PV | | 500nm | 500nm | 500nm |
| RMS | | 0.8nm | 0.8nm | 0.8nm |
| Secondary polishing | | | | |
| polishing medium | | cerium oxide | cerium oxide | cerium oxide |
| rev./min. | | 40 | 50 | 40 |
| polishing pad | | N0030 (Kanebo) | SPM3100 (Rodel) | N0020 (Kanebo) |
| After secondary polishing | | | | |
| PV | | 500nm | 500nm | 500nm |
| RMS | | 0.3nm | 0.3nm | 0.3nm |

(continued)

| Example | 1 | 2 | 3 |
|---|---|---|---|
| **After process (b)** | | | |
| PV | 100nm | 100nm | 100nm |
| RMS | 0.35nm | 0.35nm | 0.35nm |
| **Process (a)** | | | |
| **Process (a-1)** | | | |
| polishing medium | cerium oxide | cerium oxide | cerium oxide |
| concentration | 0.3wt% | 0.1wt% | 0.2wt% |
| polishing pad | N0030 (Kanebo) | SPM3100 (Rodel) | N0020 (Kanebo) |
| rev./min. | 50 | 50 | 50 |
| surface load | 40g/cm$^2$ | 40g/cm$^2$ | 40g/cm$^2$ |
| polishing time | 10 min. | 10 min. | 10 min. |
| **Process (a-2)** | | | |
| liquid | tap water | tap water | tap water |
| polishing pad | N0030 (Kanebo) | SPM3100 (Rodel) | N0020 (Kanebo) |
| rev./min. | 40 | 50 | 40 |
| surface load | 40g/cm$^2$ | 40g/cm$^2$ | 40g/cm$^2$ |
| polishing time | 15 min. | 10 min. | 15 min. |
| **After process (a)** | | | |
| PV | 220nm | 100nm | 210nm |
| RMS | 0.22nm | 0.17nm | 0.21nm |
| Ra | 0.18nm | 0.14nm | 0.17nm |

Table 2

| Example | 4 | 5 |
|---|---|---|
| **Material** | | |
| $SiO_2$(wt%) | 55.5 | 55.5 |
| $TiO_2$(wt%) | 2.3 | 2.3 |
| $P_2O_5$(wt%) | 7.5 | 7.6 |
| $Al_2O_3$(wt%) | 24.5 | 24.4 |
| $Li_2O$(wt%) | 3.95 | 3.97 |
| $MgO$(wt%) | 1.0 | 1.0 |
| $ZnO$(wt%) | 0.5 | 0.5 |
| $CaO$(wt%) | 1.05 | 1.03 |
| $BaO$(wt%) | 1.0 | 1.0 |
| $ZrO_2$(wt%) | 2.0 | 2.0 |
| $As_2O_3$(wt%) | 0.7 | 0.7 |
| **Predominant Crystal phase** | β-quartz/ β-quart solid solution | β-quartz/ β-quartz solid solution |

(continued)

| Example | 4 | 5 |
|---|---|---|
| $\alpha$(0 - 50˚C) | $0.1\times10^{-7}$ | $0.1\times10^{-7}$ |
| $\alpha$(19 - 25˚C) | $0.1\times10^{-7}$ | $0.1\times10^{-7}$ |
| **Primary polishing** | | |
| polishing medium | cerium oxide | cerium oxide |
| rev./min. | 50 | 50 |
| polishing pad | MHC15A (Rodel) | MHC15A (Rodel) |
| **After primary polishing** | | |
| PV | 500nm | 500nm |
| RMS | 0.8nm | 0.8nm |
| **Secondary polishing** | | |
| polishing medium | cerium oxide | cerium oxide |
| rev./min. | 40 | 40 |
| polishing pad | SPM3100 (Rodel) | N0020 (Kanebo) |
| **After secondary polishing** | | |
| PV | 500nm | 500nm |
| RMS | 0.3nm | 0.3nm |
| **After process (b)** | | |
| PV | 100nm | 100nm |
| RMS | 0.35nm | 0.35nm |
| **Process (a)** | | |
| **Process (a-1)** | | |
| polishing medium | cerium oxide | cerium oxide |
| concentration | 0.1wt% | 0.5wt% |
| polishing pad | SPM3100 (Rodel) | N0020 (Kanebo) |
| rev./min. | 50 | 50 |
| surface load | 40g/cm$^2$ | 40g/cm$^2$ |
| polishing time | 10 min. | 10 min. |
| **Process (a-2)** | | |
| liquid | tap water | tap water |
| polishing pad | SPM3100 (Rodel) | Apollon-p (Rodel) |
| rev./min. | 40 | 40 |
| surface load | 40g/cm$^2$ | 40g/cm$^2$ |
| polishing time | 15 min. | 15 min.. |
| **After process (a)** | | |
| PV | 100nm | 210nm |
| RMS | 0.17nm | 0.19nm |
| Ra | 0.14nm | 0.15nm |

According to the method of the present invention, there can be provided substrates having excellent flatness and surface roughness in the high accuracy region, particularly substrates for liquid crystal display and electronic devices including semiconductor wafers or information recording medium and, more particularly, masks and mirrors and substrates for such masks and mirrors for EVU micro-lithography.

## Claims

1. A method for polishing a substrate comprising
   (a) a process of polishing an object to be polished with a polishing pad comprising at least one layer made of a resin film and having compressibility of 0.8 % or below in a base layer of the polishing pad.

2. A method as defined in claim 1, wherein the process (a) comprises:
   (a-1) a process of polishing an object to be polished by a polisher while maintaining surface load of 40 g/cm$^2$ or below to the object to be polished and supplying a polishing medium.

3. A method as defined in claim 2, wherein the process (a) comprises:
   (a-2) a process performed subsequent to the process (a-1) of polishing the object to be polished by the polisher while supplying only liquid which does not contain a polishing medium.

4. A method as defined in claim 3 wherein surface load to the object to be polished is maintained at 40 g/cm$^2$ or below in the process (a-2).

5. A method as defined in any of claims 1 to 4 wherein, after the polishing, flatness of the object to be polished is less than 230 nmPV and surface roughness at RMS of the object to be polished is less than 0.20 nm.

6. A method as defined in any of claims 1 to 5 comprising:

   (b) a process performed prior to the process (a) of polishing the object to be polished to flatness of at least 230 nmPV and surface roughness at RMS of at least 0.4 nm.

7. A method as defined in any of claims 1 to 6 wherein the polishing medium used in the process (a) is a cerium oxide polishing media.

8. A method as defined in any of claims 1 to 7 wherein an average particle diameter of the polishing medium used in the process (a) is 1.0 $\mu$m or below.

9. A method as defined in any of claims 1 to 8 wherein concentration of the polishing medium used in the process (a) is 1.0 wt% or below.

10. A method as defined in any of claims 1 to 9 wherein the substrate is a substrate for a photo mask.

## Patentansprüche

1. Verfahren zum Polieren eines Substrats, umfassend:

   (a) ein Verfahren zum Polieren eines zu polierenden Objekts mit einer Polierscheibe, die wenigstens eine Schicht umfasst, die aus einem Harzfilm besteht und in einer Basisschicht der Polierscheibe eine Kompressibilität von 0,8% oder darunter aufweist.

2. Verfahren gemäß Anspruch 1, wobei das Verfahren (a) Folgendes umfasst:

   (a-1) ein Verfahren zum Polieren eines zu polierenden Objekts mit einem Schleifer, während eine Oberflächenbelastung von 40 g/cm$^2$ oder darunter auf das zu polierende Objekt aufrechterhalten wird, und Zuführen eines Poliermittels.

3. Verfahren gemäß Anspruch 2, wobei das Verfahren (a) Folgendes umfasst:

(a-2) ein Verfahren, das im Anschluss an Verfahren (a-1) zum Polieren des zu polierenden Objekts mit dem Schleifer durchgeführt wird, während nur Flüssigkeit zugeführt wird, die kein Poliermittel enthält.

4. Verfahren gemäß Anspruch 3, wobei die Oberflächenbelastung des zu polierenden Objekts im Verfahren (a-2) auf 40 g/cm$^2$ oder darunter gehalten wird.

5. Verfahren gemäß einem der Ansprüche 1 bis 4, wobei nach dem Polieren die Ebenheit des zu polierenden Objekts kleiner als 230 nmPV beträgt und die quadratische Oberflächenrauigkeit des zu polierenden Objekts kleiner als 0,20 nm ist.

6. Verfahren gemäß einem der Ansprüche 1 bis 5, umfassend:

   (b) ein Verfahren, das vor dem Verfahren (a) zum Polieren des zu polierenden Objekts auf eine Ebenheit von wenigstens 230 nmPV und eine quadratische Oberflächenrauigkeit von wenigstens 0,4 nm durchgeführt wird.

7. Verfahren gemäß einem der Ansprüche 1 bis 6, wobei das in Verfahren (a) verwendete Poliermittel ein Ceroxid-Poliermittel ist.

8. Verfahren gemäß einem der Ansprüche 1 bis 7, wobei der mittlere Teilchendurchmesser des in Verfahren (a) verwendeten Poliermittels 1,0 μm oder weniger beträgt.

9. Verfahren gemäß einem der Ansprüche 1 bis 8, wobei die Konzentration des in Verfahren (a) verwendeten Poliermittels 1,0 Gew.-% oder weniger beträgt.

10. Verfahren gemäß einem der Ansprüche 1 bis 9, wobei das Substrat ein Substrat für eine Photomaske ist.

**Revendications**

1. Procédé pour polir un substrat comprenant:

   (a) un procédé pour polir un objet à polir avec un tampon de polissage comprenant au moins une couche consistant en un film de résine et ayant une compressibilité de 0,8% ou moins dans une couche de base du tampon de polissage.

2. Procédé selon la revendication 1, dans lequel ledit procédé (a) comprend:

   (a-1) un procédé pour polir un objet à polir avec un polissoir lorsqu'une charge de surface de 40 g/cm$^2$ ou moins à l'objet à polir est maintenue, et alimenter un milieu de polissage.

3. Procédé selon la revendication 2, dans lequel ledit procédé (a) comprend:

   (a-2) un procédé effectué après le procédé (a-1) pour polir l'objet à polir avec le polissoir, pendant lequel seulement du liquide qui ne contient pas de milieu de polissage est alimenté.

4. Procédé selon la revendication 3, dans lequel la charge de surface à l'objet à polir est maintenue à 40 g/cm$^2$ ou moins dans le procédé (a-2).

5. Procédé selon l'une quelconque des revendications 1 à 4, dans lequel la planéité de l'objet à polir est moins de 230 nm (pic à creux) et la rugosité quadratique moyenne de surface de l'objet à polir est moins de 0,20 nm après le polissage.

6. Procédé selon l'une quelconque des revendications 1 à 5, comprenant:

   (b) un procédé effectué avant le procédé (a) pour polir l'objet à polir à une planéité d'au moins 230 nm (pic à creux) et à une rugosité quadratique moyenne de surface d'au moins 0,4 nm.

7. Procédé selon l'une quelconque des revendications 1 à 6, dans lequel le milieu de polissage utilisé dans le procédé (a) est un milieu de polissage à base d'oxyde de cérium.

8.  Procédé selon l'une quelconque des revendications 1 à 7, dans lequel le diamètre moyen de particules du milieu de polissage utilisé dans le procédé (a) est de 1,0 $\mu$m ou moins.

9.  Procédé selon l'une quelconque des revendications 1 à 8, dans lequel la concentration du milieu de polissage utilisé dans le procédé (a) est de 1,0% en poids ou moins.

10.  Procédé selon l'une quelconque des revendications 1 à 9, dans lequel le substrat est un substrat pour un masque photographique.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040166420 A1
- US 20060140105 A1
- US 20030077036 A1
- WO 2006082751 A2

- US 20050064709 A1
- US 20020098779 A1
- JP 2004228563 A
- JP 2004029735 A


**Non-patent literature cited in the description**

- *Journal of Abrasive Grain Processing Institute,* August 2002, vol. 146 (8